# FASCICULE DE BREVET EUROPEEN

(11) **EP 0 828 688 B1**
(45) Date de publication et mention de la délivrance du brevet: **19.05.1999**
(21) Numéro de dépôt: 95940327.0
(22) Date de dépôt: 17.11.1995
(51) Int. Cl.: C01B 21/072, H01L 23/15, C03C 11/00, C22C 32/00

(54) **GRANULES DE NITRURE D'ALUMINIUM**
ALUMINIUMNITRIDGRANULATE
ALUMINIUM NITRIDE GRANULES

(30) Priorité: 18.11.1994 FR 9413843
(43) Date de publication de la demande: 18.03.1998
(73) Titulaire: Cernix, 35235 Thorigne-Fouillard (FR)
(72) Inventeur: DUCEL-VIOT, Bénédicte, F-53320 Beaulieu (FR); GARNIER, Corinne, F-35340 Liffre (FR); LAURENT, Yves, F-35235 Thorigne-Fouillard (FR); RAZAFINDRAKOTO, John, F-35235 Thorigne-Fouillard (FR); VERDIER, Patrick, F-35690 Acigne (FR); BENITEZ JIMENEZ, José Jésus, E-41700 Dos Hernanas (ES); CENTENO GALLEGO, Michel Anguel, E-41700 Sevilla (ES); ODRIOZOLA GORDON, José Antonio, E-41002 Sevilla (ES)
(74) Mandataire: Le Forestier, Eric
(86) Numéro de dépôt international: FR9501515
(87) Numéro de publication internationale: WO9615982

(56) Documents cités:
- EP-A- 0 571 251
- FR-A- 2 681 590
- JOURNAL OF MATARIALS SCIENCE LETTERS, vol. 8, no. 3, 1989 LONDON (GB), pages 303-304, I. KIMURA ET AL. 'Synthesis of fine AlN powder by a floating nitridation technique using an N2/NH3 gas mixture.'
- CHEMICAL ABSTRACTS, vol. 109, no. 12, 19 Septembre 1988 Columbus, Ohio, US; abstract no. 97632n, 'Continuous synthesis of fine aluminium nitride powder by floating nitridation and its properties.' page 282; & NIPPON SERAMIKKUSU KYOKAI GAKUJUTSU RONBUNSHI, vol. 96, no. 7, pages 731-735,
- DATABASE WPI Section Ch, Week 8750 Derwent Publications Ltd., London, GB; Class E37, AN 352544 MURATA MFG 'Non-oxidised metal powder production.' & JP,A,62 256 702 (MURATA MFG) , 9 Novembre 1987

## Description

La présente invention concerne un nouveau procédé de préparation de granulés d'aluminium partiellement ou totalement nitruré, les granulés ainsi obtenus et leur utilisation.

Le nitrure d'aluminium est un matériau bien connu, très avantageux notamment pour son utilisation dans la fabrication de substrats pour circuits intégrés, en électronique ou encore pour la fabrication de divers matériaux expansés, notamment de mousse de verre.

Différents procédés de préparation de nitrure d'aluminium ont été décrits dans l'état de la technique, comme par exemple la nitruration directe de Al₂O₃ par l'ammoniac à 1300°C décrite dans FR-A-2 571 041 (CNRS).

D'autres procédés de préparation et les dispositifs tubulaires pour leur mise en oeuvre sont notamment décrits dans les demandes de brevet FR-A-2 681 590 et FR-A-2 594 109, dans lesquels la réaction de nitruration est effectuée en présence d'un agent d'activation, en particulier un composé lithié. Toutefois, les produits pulvérulents obtenus par un tel procédé nécessitent des précautions particulières pour leur stockage et leur utilisation, sous gaz inerte, puisque le nitrure d'aluminium aura tendance à s'hydrolyser sous atmosphère ambiante en présence de H₂O, libérant de l'ammoniac.

Le taux de nitruration de l'aluminium dépend de différents paramètres tels que le temps de réaction (temps de contact entre la poudre d'aluminium à nitrure et l'agent de nitruration) ou encore sa température, l'homme du métier sachant parfaitement définir lesdits paramètres pour obtenir une nitruration complète de l'aluminium, ou simplement partielle.

Toutefois, jusqu'à présent la nitruration partielle de l'aluminium n'était pas particulièrement recherchée, compte tenu du fait que l'on obtenait un mélange Al₂O₃/AlN par les procédés usuels de nitruration de l'aluminium, aucun de ces procédés ne permettant de ce fait d'obtenir un mélange Al/AlN comprenant jusqu'à 40% en poids d'AIN particulièrement intéressant pour la fabrication de composites de type "cermets" AI-AIN de densités voisines de 3. Du fait de leurs faibles densités et de leurs caractéristiques physico-chimiques supérieures à celle de l'aluminium métallique, ces cermets peuvent trouver des applications dans un grand nombre de domaines.

La présente invention concerne donc un nouveau procédé de préparation de granulés d'aluminium nitruré, totalement ou en partie, stables au stockage, qui peuvent être maintenus sous atmosphère normale sans être hydrolysés et dégager de l'ammoniac, les granulés obtenus par le procédé étant enrobés par une couche passivante de carbonate de calcium (CaCO₃).

Le procédé selon l'invention permet ainsi d'obtenir des granulés d'un mélange d'aluminium et de nitrure d'aluminium comprenant jusqu'à 40% en poids de nitrure d'aluminium qui permet de fabriquer des cermets que l'on ne saurait obtenir par un autre procédé.

Le procédé selon l'invention consiste à faire réagir, sous agitation continue, de la poudre d'aluminium en mélange avec une quantité appropriée de CaCO₃ pulvérulent, avec de l'azote en chauffant le milieu réactionnel à une température appropriée.

Par quantité appropriée de CaCO₃, on entend la quantité nécessaire à l'obtention d'une couche au moins mono-moléculaire continue de composé passivant autour des granulés d'aluminium nitruré obtenus par le procédé selon l'invention.

D'une manière avantageuse, le mélange pulvérulent comprend entre 1 et 5% en poids de CaCO₃, plus avantageusement environ 1,5% en poids de CaCO₃.

La température appropriée est celle des techniques usuelles de préparation d'AIN par réaction d'aluminium et d'azote particulier décrites dans FR-A-2 681 590. Elle est comprise entre 600°C et 1200°C, avantageusement inférieure à 1000°C, encore plus avantageusement voisine de 900°C.

De préférence, la poudre d'aluminium utilisée dans le procédé selon l'invention a une granulométrie moyenne comprise entre 0,1 et 100 µm, de préférence entre 0,5 et 60 µm.

Lorsque l'on utilise une poudre d'aluminium de granulométrie moyenne comprise entre 0,5 et 10 µm, on obtient des résultats parfaitement satisfaisants, les granulés de nitrure d'aluminium obtenus étant particulièrement adaptés pour des applications électroniques, voire aussi comme agent d'expansion dans la fabrication d'aluminosilicates expansés. Pour d'autres applications, imposant par exemple des conditions de frittage particulières, il peut être avantageux d'avoir recours à des granulométries plus élevées.

En particulier, pour l'obtention d'aluminium partiellement nitruré, et plus particulièrement pour l'obtention de "cermets", on emploiera avantageusement une poudre d'aluminium dont le diamètre moyen est compris entre 50 et 60µm.

Selon un premier mode de réalisation du procédé selon l'invention, l'agitation continue du mélange réactionnel se fait au moyen d'un four tournant.

Selon un autre mode de réalisation du procédé selon l'invention, l'agitation continue se fait au moyen d'un réacteur à lit balayé ou d'un réacteur à lit fluidisé.

Dans les deux cas, on introduit le mélange pulvérulent d'aluminium et de carbonate de calcium dans le four, sous une atmosphère d'azote qui est introduite à contre courant du mélange pulvérulent.

D'une manière avantageuse, l'azote est introduit à une vitesse spatiale horaire, quotient du débit gazeux traversant le réacteur par la section de passage dudit réacteur, comprise entre 6.000 et 15.000 m. h⁻¹.

L'homme du métier saura bien entendu adapter les paramètres du procédé selon l'invention pour obtenir une nitruration complète ou partielle de l'aluminium, l'essentiel étant de s'assurer que la poudre d'aluminium mise à réagir en mélange avec de la poudre de CaCO₃ est bien maintenue sous agitation.

Les phénomènes physico-chimiques qui conduisent à la formation des granulés selon l'invention, plutôt qu'à une poudre telle qu'obtenue par le procédé sans agitation tel que décrit par exemple dans FR-A-2 681 590, ne sont pas encore bien compris.

Il apparaît, par analyse thermique différentielle, que la réaction est très exothermique. En effet on a pu observer une augmentation en température de 50°C au-dessus de la température programmée pour une prise d'essais de 10 à 20 mg, et on a émis l'hypothèse qu'il s'agissait d'une réaction auto-entretenue, la température de flamme au moment de la nitruration étant d'environ 4000°K.

Il semblerait que l'agitation du mélange réactionnel fasse s'entrechoquer les grains de poudre d'aluminium entraînant localement une augmentation de température des grains au cours de la nitruration et un préfrittage de l'AIN ainsi obtenu, c'est-à-dire son agglomération pour former des granulés d'un diamètre moyen compris entre 5 et 40 mm, très supérieur à celui des grains de la poudre d'aluminium mise à réagir.

Les granulés obtenus par le procédé ci-dessus, présentent des propriétés particulièrement intéressantes, tant pour des granulés essentiellement constitués par de l'AIN (aluminium totalement nitruré) que pour de l'aluminium partiellement nitruré, en particulier les granulés pour "cermets" comprenant jusqu'à 40% en poids de nitrure d'aluminium.

La présente invention concerne donc également de nouveaux granulés d'aluminium nitruré, totalement ou en partie, constitués par un noyau en aluminium nitruré, totalement ou en partie, et enrobés d'une couche passivante d'un composé passivant approprié, en particulier de carbonate de calcium.

Les granulés selon l'invention présentent de préférence un diamètre moyen compris entre 5 et 40 mm.

Par diamètre moyen, on entend la dimension des mailles d'un tamis dans lesquelles s'écouleraient par gravité les granulés selon l'invention.

La couche passivante du composé passivant est au moins mono-moléculaire, continue, c'est-à-dire, pour le carbonate de calcium, une épaisseur moyenne d'au moins 10 Angström.

Bien entendu, la couche passivante peut avoir une épaisseur supérieure à celle d'une couche mono-moléculaire.

Toutefois, d'une manière particulièrement avantageuse, la couche passivante sera essentiellement mono-moléculaire, c'est-à-dire présentant la quantité minimum de composé passivant approprié permettant de créer une couche continue autour du noyau d'aluminium nitruré assurant sa passivation sans dénaturer pour autant les propriétés physico-chimiques de ce produit.

Le rapport pondéral noyau d'aluminium nitruré/CaCO₃ sera avantageusement compris entre 20:1 et 100:1, avantageusement supérieur ou égal à 50:1.

Lorsque l'on prépare des "cermets" d'Al-AIN, les granulés selon l'invention contiennent jusqu'à 40% en poids de nitrure d'aluminium, calculé sur le poids total du noyau.

D'une manière avantageuse, ils comprennent entre 5 et 30% en poids de nitrure d'aluminium.

D'autres caractéristiques des granulés et du procédé selon l'invention apparaîtront à la lumière des exemples ci-après.

### EXEMPLE 1: Préparation de granulés d'AlN stabilisés

L'aluminium utilisé est un aluminium du commerce qui se présente sous une forme lamellaire, d'une densité apparente de 0,5 et d'une surface spécifique, mesurée au BET, de 4,95 m²/g.

Le carbonate de calcium est aussi un carbonate du commerce dont la densité apparente est de 2,7.

10 kg de poudre d'aluminium et 150 gr de carbonate de calcium son mélangés pendant une heure dans un mélangeur industriel rotatif en V, le mélange ainsi obtenu est ensuite versé dans la trémie d'alimentation d'un four tournant.

Le four tournant comprend un réacteur rotatif parfaitement étanche, différentes zones de chauffe, une trémie d'alimentation, un bac de récupération et un circuit d'alimentation en gaz.

Dans cet exemple, le réacteur tourne à une vitesse de 3 tours par minute, avec une température de travail de 880°C. Son angle d'inclination est d'environ 2°. Le temps de passage de la poudre dans le réacteur dépend de cette inclinaison.

L'alimentation du réacteur en poudre se fait en sens contraire de l'arrivée d'azote. Le débit d'azote sera choisi pour atteindre une vitesse spatiale horaire de l'ordre de 9.000 m.h-1. L'alimentation en poudre est réglée à une vitesse de distribution de 20 g/mn.

Le nitrure d'aluminium est récupéré sous forme de granulats gris-blanc de tailles moyennes de l'ordre du centimètre.

### EXEMPLE 2: Etude de stabilité de l'AlN stabilisé

### a/ Spectroscopie

Les granulés selon l'invention obtenus en exemple 1 ci-après (AIN-gris) ont été comparés à de l'AIN "Stark" du Commerce (ci-après AIN-S), à de l'AlN préparé en faisant réagir de l'Al₂O₃ et de l'ammoniac (ci-après AIN-blanc), et à de l'AIN obtenu selon le procédé décrit dans la demande de brevet FR-A-2 681 590 (ci-après AIN-FR).

La composition des différents produits a été étudiée par spectroscopie IR en réflectance diffuse à transformée de FOURIER (DRIFTS).

L'ensemble des échantillons analysés présentant une bande importante à 1000 cm⁻¹ caractéristique de la liaison AIN.

Par contre, les spectres des échantillons AlN-S, AlN-blanc et AIN-FR présentent chacun les bandes caractéristiques des fonctions NH et OH entre 3000 et 4000 cm⁻¹, alors que le spectre de l'échantillon AlN-gris selon l'invention est plat à ces mêmes nombres d'ondes.

La présence des bandes OH et NH pour les spectres des échantillons AIN-S, AIN-blanc et AIN-FR, est caractéristique d'une hydrolyse de l'AIN sous atmosphère ambiante qui entraîne la formation de Al(OH)₃ et de NH₃.

L'absence de ces bandes pour le spectre de l'AIN-gris selon l'invention montre bien l'absence d'hydrolyse, compte tenu de la présence d'une couche protectrice passivante de CaCO₃.

### b/ Test olfactif

Un autre moyen de vérifier la stabilité des granulés selon l'invention consiste simplement à constater la présence ou l'absence de l'odeur caractéristique de l'ammoniac.

Dans les échantillons AIN-S, AlN-blanc et AIN-FR, laissés à l'air ambiant, on observe rapidement le dégagement d'une odeur caractéristique de la présence d'ammoniac.

Par contre, pour les échantillons d'AlN-gris selon l'invention, on n'observe pas de dégagement d'odeur d'ammoniac, ce qui vient confirmer la stabilité améliorée du produit selon l'invention, comparée à celle des échantillons de l'état de la technique.

### EXEMPLE 3: Préparation de granulés stabilisés pour la fabrication de "cermets" (Al/AIN)

L'aluminium utilisé est un aluminium du commerce qui se présente sous forme de poudre de grains sphériques d'une densité apparente de 0,8 et d'une surface spécifique mesurée au BET de 0,27 m²/g.

Le diamètre moyen des sphères est de 50 à 60 µm. Le carbonate est aussi un carbonate du commerce dont la densité apparente est de 2,7.

10 kg de poudre d'aluminium et 300 g de CaCO₃ sont mélangés pendant une heure dans un mélangeur industriel, le mélange ainsi obtenu est ensuite versé dans la trémie d'alimentation d'un four tournant.

L'alimentation en poudre dans le réacteur se fait en sens contraire de l'arrivée d'azote. Le débit d'azote sera choisi pour atteindre une vitesse spatiale horaire de l'ordre de 12000 mh-1.

Le temps de passage de la poudre dans le réacteur conditionne le pourcentage d'azote souhaité. Le temps de passage est déterminé par la vitesse de rotation du réacteur ainsi que de l'inclinaison de celui-ci. La température de travail est de 850°C.

Les granulés obtenus ont une composition en nitrure d'aluminium comprise entre 0 et 40% en masse. Ils peuvent être avantageusement utilisés pour la fabrication de "cermets" qui sont des composites céramique-métal. Du fait des densités respectives des deux constituants d_{AI}=2,70 et dAlN=3,26. Ces composites possèdent, selon leur composition, des densités voisines de 3. La présence de nitrure d'aluminium réparti de façon homogène dans l'aluminium permet d'améliorer de façon significative ses propriétés physiques, mécaniques et chimiques. Les cermets ainsi préparés peuvent trouver des applications en aéronautiques, en aérospatiale, en microélectronique comme par exemple la fabrication de boîtiers de grande dimension, et de faible masse et dans tout autre domaine nécessitant de bonne propriétés mécaniques associées à une faible densité.

## Revendications

1. Procédé de préparation de granulés d'aluminium nitruré, totalement ou en partie, stables au stockage, enrobés par une couche passivante de carbonate de calcium (CaCO3), caractérisé en ce que l'on fait réagir sous agitation continue de la poudre d'aluminium, mélangée avec une quantité appropriée de CaCO₃ pulvérulent, avec de l'azote, en chauffant le milieu réactionnel à une température appropriée.

2. Procédé selon la revendication 1, caractérisé en ce que le mélange pulvérulent comprend entre 1 et 5% en poids de CaCO₃, avantageusement 1,5% en poids.

3. Procédé selon l'une des revendications 1 ou 2, caractérisé en ce que la température appropriée est comprise entre 600°C et 1200°C, avantageusement inférieure à 1000°C, encore plus avantageusement voisine de 900°C.

4. Procédé selon l'une des revendications 1 à 3, caractérisé en ce que la poudre d'aluminium a une granulométrie moyenne comprise entre 0,1 et 100 µm, de préférence comprise entre 0,5 et 60 µm.

5. Procédé selon l'une des revendications 1 à 4, caractérisé en ce que l'agitation continue du mélange réactionnel se fait au moyen d'un four tournant, d'un réacteur à lit fluidisé ou d'un réacteur à lit balayé.

6. Procédé selon la revendication 5, caractérisé en ce que l'atmosphère d'azote est introduite à contre-courant du mélange pulvérulent, avantageusement à une vitesse spatiale horaire comprise entre 6.000 et 15.000 m. h⁻¹.

7. Granulés d'aluminium nitruré, totalement ou en partie, caractérisés en ce qu'ils sont obtenus par le procédé selon l'une des revendications 1.à 6.

8. Granulés d'aluminium nitruré, totalement ou en partie, caractérisés en ce qu'il sont constitués par un noyau en aluminium nitruré, totalement ou en partie, enrobé par une couche passivante de carbonate de calcium (CaCO₃).

9. Granulés selon la revendication 8, caractérisés en ce qu'ils présentent un diamètre moyen compris entre 5 et 40 mm.

10. Granulés selon l'une des revendications 8 ou 9, caractérisés en ce que la couche passivante est au moins mono-moléculaire et continue.

11. Granulés selon l'une des revendications 8 à 10, caractérisés en ce que la couche passivante est essentiellement mono-moléculaire.

12. Granulés selon l'une des revendications 8 à 11, caractérisés en ce que le rapport pondéral noyau d'aluminium nitruré CaCO₃ est compris entre 20:1 et 100:1, avantageusement supérieur ou égal à 50:1.

13. Granulés selon l'une des revendications 8 à 12, caractérisés en ce qu'ils contiennent jusqu'à 40% en poids de nitrure d'aluminium, calculé sur le poids total du noyau.

14. Granulés selon la revendication 13, caractérisés en ce qu'ils comprennent entre 5 et 30% en poids de nitrure d'aluminium.

15. Utilisation de granulés selon l'une des revendications 7 à 14, pour la fabrication de substrats de circuits intégrés.

16. Utilisation de granulés selon l'une des revendications 7 à 14, pour la fabrication de matériaux expansés.

17. Utilisation de granulés selon l'une des revendications 7 à 14 pour la fabrication de cermets.

## Claims

1. A method of preparing aluminum granules that are partially or completely nitrided and that are stable in storage, being coated in a passivating layer of calcium carbonate (CaCO₃), the method being characterized by the fact that aluminum powder mixed with an appropriate quantity of powdered CaCO₃ is reacted with nitrogen under continuous stirring while heating the reaction medium to an appropriate temperature.

2. A method according to claim 1, characterized in that the powder mixture has 1% to 5% by weight of CaCO₃, advantageously 1.5% by weight.

3. A method according to claim 1 or 2, characterized in that the appropriate temperature lies in the range 600°C to 1200°C, is advantageously less than 1000°C, and more advantageously is close to 900°C.

4. A method according to any one of claims 1 to 3, characterized in that the mean grain size of the aluminum powder lies in the range 0.1 µm to 100 µm, and preferably lies in the range 0.5 µm to 60 µm.

5. A method according to any one of claims 1 to 4, characterized in that the reaction mixture is stirred continuously by means of a rotary oven, a fluidized bed reactor, or a swept bed reactor.

6. A method according to claim 5, characterized in that the nitrogen atmosphere is injected as a counterflow to the powder mixture, advantageously at a linear speed per hour lying in the range 6000 m.h⁻¹ to 15,000 m.h⁻¹.

7. Partially or completely nitrided aluminum granules, characterized in that they are obtained by the method according to any one of claims 1 to 6.

8. Partially or completely nitrided aluminum granules, characterized in that they are constituted by a partially or totally nitrided aluminum core coated in a passivating layer of calcium carbonate (CaCO₃).

9. Granules according to claim 8, characterized in that they have a mean diameter lying in the range 5 mm to 40 mm.

10. Granules according to claim 8 or 9, characterized in that the passivating layer is continuous and at least monomolecular.

11. Granules according to any one of claims 8 to 10, characterized in that the passivating layer is essentially monomolecular.

12. Granules according to any one of claims 8 to 11, characterized in that the weight ratio of the aluminum nitride core to CaCO₃ lies in the range 20:1 to 100:1, and is advantageously greater than or equal to 50:1.

13. Granules according to any one of claims 8 to 12, characterized in that they contain up to 40% by weight of aluminum nitride, relative to the total weight of the core.

14. Granules according to claim 13, characterized in that they comprise 5% to 30% by weight of aluminum nitride.

15. The use of granules according to any one of claims 7 to 14, for manufacturing integrated circuit substrates.

16. The use of granules according to any one of claims 7 to 14, for manufacturing expanded materials.

17. The use of granules according to any one of claims 7 to 14, for manufacturing cermets.

## Patentansprüche

1. Verfahren zur Herstellung von lagerungsstabilen Granulaten von ganz oder teilweise nitridiertem Aluminium, umhüllt mit einer passivierenden Schicht von Calciumcarbonat (CaCO₃), dadurch gekennzeichnet, daß man Aluminiumpulver, vermischt mit einer geeigneten Menge von pulverförmigem CaCO₃ unter kontinuierlichem Bewegen mit Stickstoff umsetzt, wobei man das Reaktionsmilieu auf eine geeignete Temperatur erwärmt.

2. Verfahren nach Anspruch 1, dadurch gekennzeichnet, daß die pulverförmige Mischung 1 bis 5 Gew.-% CaCO₃, bevorzugt 1,5 Gew.-% enthält.

3. Verfahren nach einem der Ansprüche 1 oder 2, dadurch gekennzeichnet, daß die geeignete Temperatur bei 600 bis 1200°C, bevorzugt unter 1000°C und besonders bevorzugt etwa 900°C beträgt.

4. Verfahren nach einem der Ansprüche 1 bis 3, dadurch gekennzeichnet, daß das Aluminiumpulver eine mittlere Granulometrie von 0,1 bis 100 µm, vorzugsweise von 0,5 bis 60 µm aufweist.

5. Verfahren nach einem der Ansprüche 1 bis 4, dadurch gekennzeichnet, daß das kontinuierliche Bewegen des Reaktionsgemischs mit einem Drehofen, einem Wirbelschichtbettreaktor oder einem Reaktor mit Strömungsbett durchgeführt wird.

6. Verfahren nach Anspruch 5, dadurch gekennzeichnet, daß die Stickstoffatmosphäre im Gegenstrom zum pulverförmigen Gemisch vorzugsweise mit einer Raumdurchsatzgeschwindigkeit von 6000 bis 15000 m. h⁻¹ eingeführt wird.

7. Granulate von ganz oder teilweise nitridiertem Aluminium, dadurch gekennzeichnet, daß sie erhalten werden nach dem Verfahren eines der Ansprüche 1 bis 6.

8. Granulate von ganz oder teilweise nitridiertem Aluminium, dadurch gekennzeichnet, daß sie aus einem ganz oder teilweise nitridiertem Kern von Aluminium, umhüllt mit einer passivierenden Schicht von Calciumcarbonat (CaCO₃) bestehen.

9. Granulate nach Anspruch 8, dadurch gekennzeichnet, daß sie einen mittleren Durchmesser von 5 bis 40 mm aufweisen.

10. Granulate nach einem der Ansprüche 8 oder 9, dadurch gekennzeichnet, daß die passivierende Schicht zumindest monomolekular und kontinuierlich ist.

11. Granulate nach einem der Ansprüche 8 bis 10, dadurch gekennzeichnet, daß die passivierende Schicht im wesentlichen monomolekular ist.

12. Granulate nach einem der Ansprüche 8 bis 11, dadurch gekennzeichnet, daß das Gewichtsverhältnis des nitridierten Aluminiumkerns zu CaCO₃ bei 20 : 1 bis 100 : 1, vorzugsweise bei über oder gleich 50 : 1 liegt.

13. Granulate nach einem der Ansprüche 8 bis 12, dadurch gekennzeichnet, daß sie bis zu 40 Gew.-% Aluminiumnitrid, berechnet auf das Gesamtgewicht des Kerns, enthalten.

14. Granulate nach Anspruch 13, dadurch gekennzeichnet, daß sie 5 bis 30 Gew.-% Aluminiumnitrid enthalten.

15. Verwendung der Granulate nach einem der Ansprüche 7 bis 14 zur Herstellung von Substraten integrierter Schaltungen.

16. Verwendung der Granulate nach einem der Ansprüche 7 bis 14 zur Herstellung von expandierten Materialien.

17. Verwendung der Granulate nach einem der Ansprüche 7 bis 14 zur Herstellung von Cermets.
